# EUROPEAN PATENT SPECIFICATION

(11) **EP 2 986 094 B1**
(45) Date of publication and mention of the grant of the patent: **24.06.2020**
(21) Application number: 15180774.0
(22) Date of filing: 12.08.2015
(51) Int. Cl.: H05K 7/14, H05K 7/20

(54) **MOBILE DATA CENTER**
MOBILES DATENZENTRUM
CENTRE DE DONNÉES MOBILE

(30) Priority: 13.08.2014 MX 2014056976
(43) Date of publication of application: 17.02.2016
(73) Proprietor: Sixsigma Networks Mexico, S.A. DE C.V., 05000 Mexico, D.F. (MX)
(72) Inventor: Leizgold, Sergio Rosengaus, 05000 Mexico, D.F. (MX); Simpson, Dax Didier, 05000 Mexioc, D.F. (MX); Saenz, Santiago Suinaga, 05000 Mexico, D.F. (MX)
(74) Representative: Loven, Keith James

(56) References cited:
- EP-A1- 2 555 605
- CN-Y- 2 548 392
- US-A1- 2008 062 647
- US-A1- 2012 155 027
- US-A1- 2012 281 357

## Description

### OBJECT OF INDUSTRIAL IMPROVEMENT

The objective of the present invention consists in a considerable improvement in the data centres already existing of this type, where by using an ISO standard container of 16.154m, 12.192m, 6.096m and 3.048m (53, 40, 20, and 10 feet) in length is accomplished to optimize the available space to install a DPC (Data Processing Centre) with the capacity for: 14, 8, 4, or 2 equipment cabinets of IT (Information Technology), with total capacities ranging from 9kW to 60kW of power and with redundancy N+1.

### BACKGROUND

The first data centres required several floors of a building or even the entire building. These facilities usually have a great impact because of the various components that needed for the maintenance of the facilities.

Therefore, the centralized information in this type of data centres is used for computers, communication equipment and other electronic equipment, and with the increasing use of the Internet, it has become essential that this type of data processing centres become much simpler, smaller and therefore that it can be transported from one place to another, in other words to be a mobile data processing centre.

In the following patent applications, various mobile data processing centres are observed, being the nearest documents to the present invention.

The first of them is the document US 2006/0082263 A1 which refers to a mobile data processing centre which is located inside a container, inside of this container it is located the portion that refers to at least a cooling unit built and disposed to extract the hot air from the second passageway and supply cool air to the first passageway in order to cool the computer equipment inside the container, and other to the electronic equipment, which is a stand-alone system that includes space to accommodate RACKS of 500 "U" of electronic equipment. The RACKS provide 130 kW of power.

The application WO 2010/065903 A1 also relates to data centres having a mobile structure, one or more enclosures for removable electronic equipment, wherein the removable enclosures are hosted in the support structure, a cooling system in fluid communication with the enclosures for the cooling of the electronic equipment in which the cooling system is hosted in the support structure, and a power system connected in operational way to electronic device and the cooling system to supply power to the same in which the supply system comprises a generator hosted in the support structure.

US 2012/155027 A1 discloses a mobile data centre having separate section for a cooling unit and a power distribution panel, the container has the capability of host a plurality of rack which can move from a position abutting a front of an enclosure cooling unit to a maintenance and access position spaced apart from the enclosure cooling unit achieved through a swivel mechanism mounted on the bottom of a rack and a movable base unit with slotted wheels. A disadvantage of said system is that the wheels only slip through the peaked rails and as a result of a bad movement there may be the possibility of a derailment.

US 2012/281357 A1 describes a container data centre which includes a container, at least one power supplying assembly, at least one cooling assembly, and at least one server assembly. The power supplying assembly, the cooling assembly, and the server assembly are received in the container. The cooling assembly is positioned between the power supplying assembly and the server assembly.

US 2008/062647 A1 describes a movable data centre that comprises a movable enclosure having partitions that define a closed-loop air flow path. A plurality of fans and a plurality of data processing modules are disposed in the air flow path. A pipe network is disposed within the enclosure that includes a chiller water supply pipe that receives chilled water from a source of chilled water. A smoke detector is also disclosed.

CN 2548392 Y discloses a mobile data centre comprises a box with a door. The inside of the box is divided into an equipment area and a power supplying and distribution area. Cabinets are mounted on rails so as to be movable.

EP 2 555 605 A1 describes a mobile data centre having control means of the racks controlling power and cooling as well as detectors for leak of the coolant or smoke.

Therefore, there is a specific need for a mobile data processing centre, wherein the conventional applications of construction of the previous DPC, do not represent a viable opportunity due to the following reasons:
- Lack of physical space in facilities/buildings.
- Requirement to update the electromechanical equipment that requires turning off equipment.
- Remote locations or difficult access.
- Requirements for temporary use wherein the investment (CapEx) is not acceptable by its cost/benefit ratio.
- Versatility of movement.

In addition to all the requirements, there are still items and requirements that cannot be ignored in a Data Processing Centre such as:
- Capacity of growth
- Redundancy
- Availability
- Reliability
- Security
- Technical support

Here is wherein the Mobile Data Centres that are organized in containers are born. In general terms, the DPC's in containers have given the opportunity to meet the requirements and needs above described in general terms. However, the existing applications have limitations that have been improved with our mobile DPC called "Kio/ATOM".

### BRIEF DESCRIPTION OF THE FIGURES

**Figure 1** is an external view of the ISO Standard container of 12.192m (40 feet) in length.
**Figure 2** is an internal view of the items comprising the mobile DPC Kio/ATOM.
**Figure 3** is a plan view of the items comprising the mobile DPC Kio/ATOM.
**Figure 4** is a view of the sheet used to strengthen the physical security of the container and provide it properties of bullet resistance.
**Figure 5** is a detail illustrating the bearings and rails at the bottom.

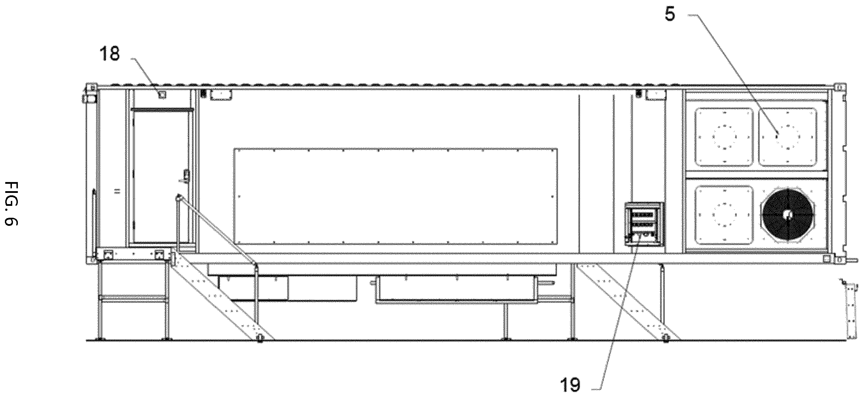

**Figure 6** is an external view of the container showing the opposite side illustrated in **Figure 1****.**
**Figure 7** is a detail showing the connection centre Razorback (**19**).
**Figure 8** is a cut of the heat exchange area (**3**).
**Figure 9** is a cut wherein are located the equipment and items that require to be permanently air-conditioned (**4**).

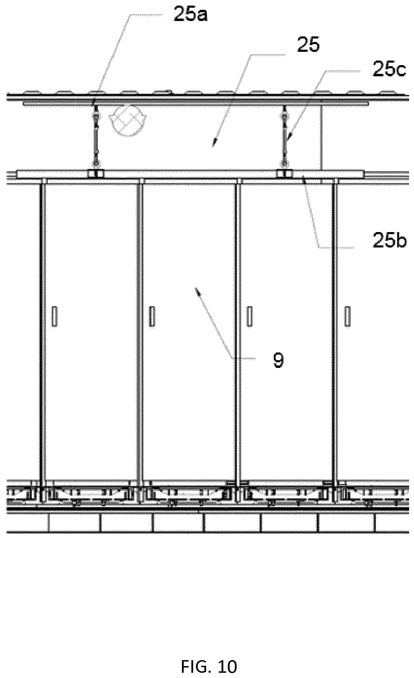

**Figure 10** is a detail illustrating the clamping means of the cabinets.

### DETAILED DESCRIPTION OF THE INDUSTRIAL IMPROVEMENT

The present invention relates to a mobile DPC (**100**) called Kio/ATOM which consists of using ISO standard containers (**1**) from 3.048m to 16.154m (10 to 53 feet) in length, which have been prepared to improve the existing offer, adapting each of their internal walls with a thermal insulation intended to maintain the required temperature in the different areas that comprise the container.

In general, the mobile DPC Kio/ATOM comprises two sections, the first section (**3**) in order to locate the heat exchangers (**5**) and the main electric distribution panel (**21**), and the second section (**4**) wherein there are located the evaporators (**8**) and the items that require to be permanently air-conditioned.

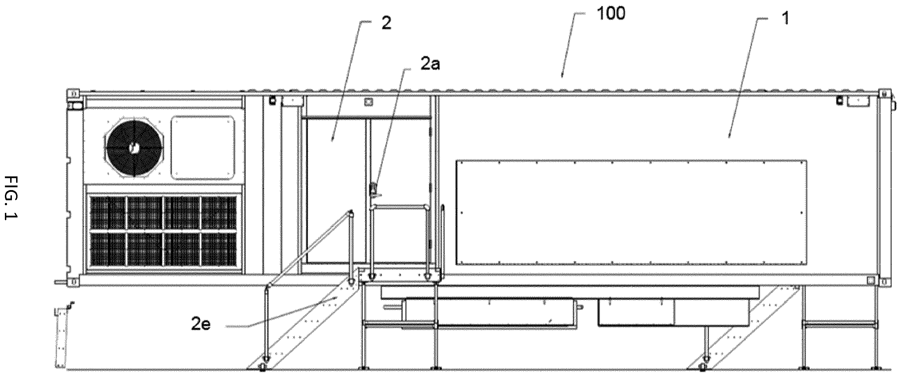

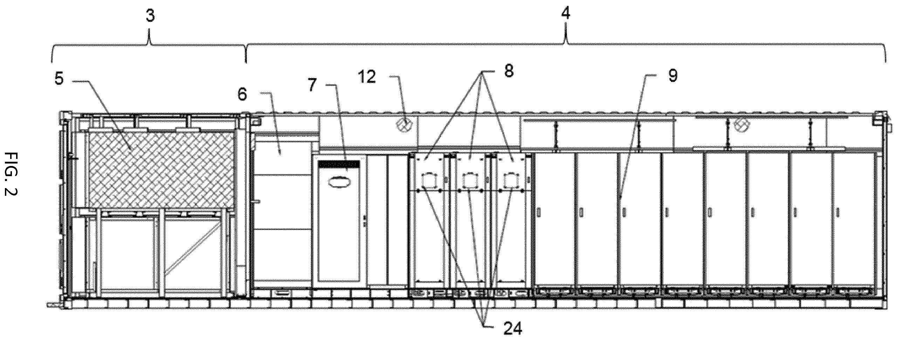

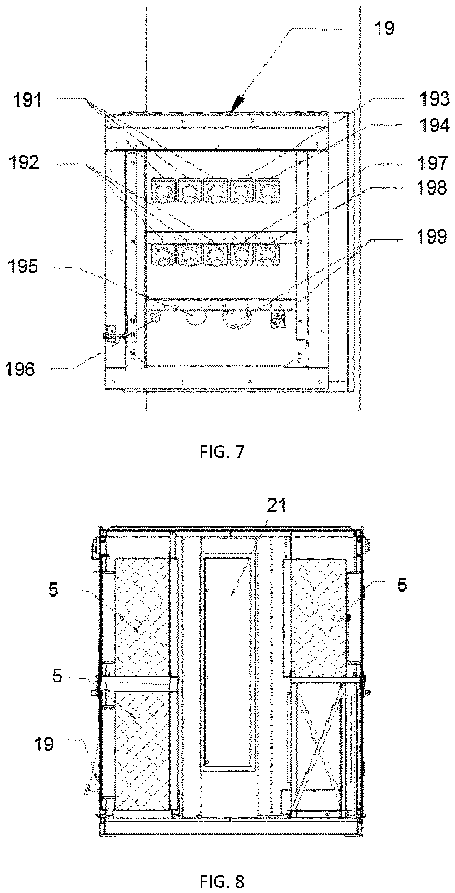

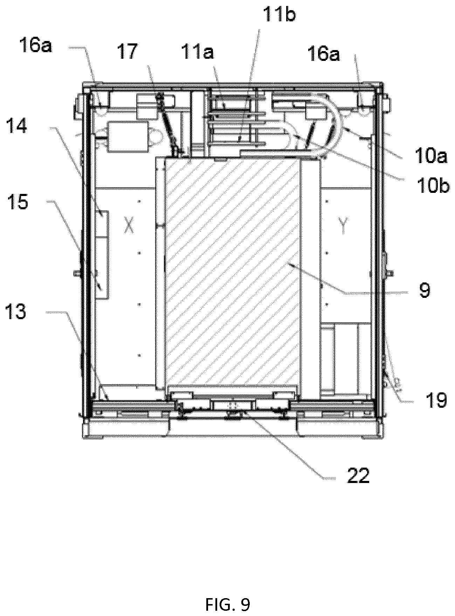

As shown in **Figures 1** and **2****,** the mobile DPC is composed by:
1. An Automatic Transfer Switch (ATS) (**6**) with Insulation Bypass for maintenance operations without the need to shut down the aforesaid equipment. The "Bypass" system consists in the motion of a lever in the ATS wherein it disables the electronic portion of the device and continues in manual operation in order to provide preventive maintenance to the electronic components,
2. An Uninterruptible Power Supply System (**7**) (UPS) from 9kW to 60kW of power capacity with redundant modules in the configuration N+1. The UPS is connected right after the ATS in order to regulate the power from service provider (Federal Electricity Commission (CFE) type) or, otherwise, regulate the power from the moto-electric generator when the power from provider is not available,
3. In the case of containers of 16.154m and 12.192m (53 and 40 feet), three evaporators (**8**) with precision of 35kW each one in the configuration N+1, and for containers of 6.096m and 3.048m (20 and 10 feet) two evaporators (**8**) with precision of 19kW each of them in the configuration N+1, which work in conjunction with heat exchangers (**5**) through a direct expansion cycle; each evaporator (**8**) comprises a smart microprocessor (**24**) which manages the temperature and relative humidity of the air-conditioned section. The microprocessor is a computer located in the front of each evaporator machine wherein the configurations required to air-condition the operating environment of the IT equipment are carried out according to requirements of equipment manufacturers. Likewise, the microprocessor operates by means of two temperature and relative humidity sensors (not shown), which are located in the same evaporators (**8**), one located in the front in order to measure both variables in the supply air outlet and another located at the back in order to measure the variables in the return air inlet in such a manner that can be ensure to have a cool aisle (**X**) and a hot aisle (**Y**) (**see** **Figure 9**). The sensors are used by a microprocessor (**24**) to calculate, using an algorithm, the parameterized requirements of temperature and relative humidity to air-condition properly the IT equipment,
4. Fourteen, eight, four or two cabinets (**9**) of 600mm in width, 1000mm depth and forty-two RMS to install the IT equipment. In order to affix the cabinets (**9**) to the container and avoid movements, each of them comprises clamping means (**25**) comprising a uni-channel (**25a**) attached to the container, a uni-channel (**25b**) attached to the cabinet and a tensor (**25c**), and on its bottom and with the purpose of facilitating its mobility, they have a bearing (**22**) and rails (**23**) system. Likewise, at the top of each cabinet, there are two flexible wire organizers (**10**), one for power (**10b**) and another for data (**10a**),
5. Two ladder type cable trays (**11**) made of stainless steel, installed perpendicularly on the top of the cabinets. One tray (**11b**) for data wiring (bottom) and other for power wiring (**11a**) (top),
6. Removable floor panels (**13**) made of aluminium and steel galvanized material,
7. High Sensitivity Smoke Detector (HSSD) (**14**) for an early detection of smoke,
8. A fire protection system using: a control panel (**15**), two abort stations (**20**) to prevent the expelling of aerosol agent in the containers (**12**) in the case of a false possibility of fire, four sirens/strobe lights (**18**), in the containers of 16.154m and 12.192m (53 and 40 feet) four containers of the aerosol agent, and in the containers of 6.096m and 3.048m (20 and 10 feet) two containers of the aerosol agent (**12**).
9. A surveillance video recording device (CCTV) and four high-resolution cameras (**16**), two internal (**16a**) and two external (**16b**).
10. Internal walls with thermal and acoustic insulator treatment of polyurethane material, and an additional galvanized steel liner.
11. LED lighting (**17**).
12. An electrical connection centre and optical fibre inlet (Razorback) (**19**), wherein the electrical connection centre is divided in preferential 3 phase power (**191**), 1 neutral (**193**), 1 ground (**194**) and 3 phase emergency power (**192**), 1 neutral (**197**), 1 ground (**198**); an optical fibre inlet (**195**); an inlet (196) for communication wiring between the emergency source and the switch (**6**); and connections for external services (**199**) (**See** **Figure 7**).

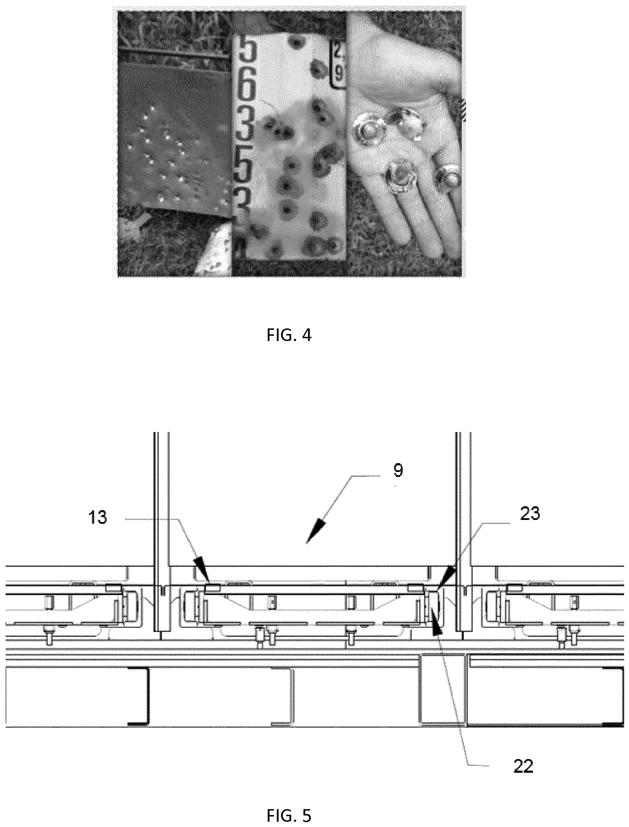

Due to space constraints, an ISO Standard container having located a cabinet in the centre of the free space do not allow the entry of the IT equipment, since a conventional server has no less than 900mm depth and the free space in front of the cabinet is only 600mm. Thus, the cabinets of the mobile DPC Kio/ATOM were designed with bearings (**22**) and rails (**23**) at the bottom (**See** **Figure 5**) to allow increasing the space in the front of the cabinets and be able to enter the IT equipment without any problem; additionally in the cabinets the flexible organizers (**10**) are placed at the top so that the displacement of the cabinets forward or backward does not affect the strength or the integrity of the electrical and data wiring that supply the services to each cabinet (**See** **Figure 2**).

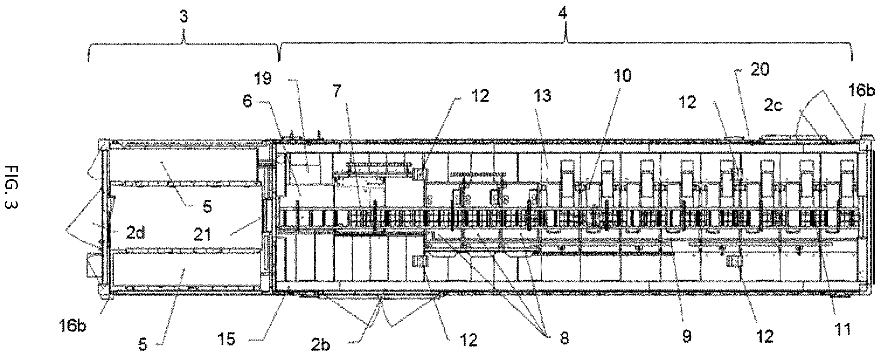

On the other hand, the space is optimized in our design by installing a fire protection system that does not use physical space on the floor; this is beneficial as it allows to host an additional cabinet for IT equipment (**See** **Figure 3**).

**Figure 4** is a representation of another improvement of the invention consisting in the installation of a galvanized steel liner which strengthens the physical security of the container making it resistant to bullets in compliance with the UL 752 standard, which ensures the Level 4 protection against projectiles of 609.6 meters per second (2,000 feet per second).

It is to be noted that the mobile data centre of the present invention also has various accesses (**2**), of which, a double gate (**2b**) provides access to the cool aisle (**X**) and ensures the suitable access for the battery maintenance of the UPS; a simple gate (**2c**) that ensures the access to the hot aisle; and the gate (**2d**) that provides access to the area (**3**) wherein the exchangers (**5**) are located.

It is important to appoint that each of the accesses (**2**) comprises an access control (**2a**) with combination keys, as well as an access ladder (**2e**) having the ability to be detachable.

### ABBREVIATIONS USED

1. **DPC:** Abbreviation for Data Processing Centre
2. **ATS:** Abbreviation for "Automatic Transfer Switch".
3. **kW:** Abbreviation for Kilowatt
4. "**N**": Abbreviation for REQUIREMENT, related to the power required in power and air conditioning for computer equipment.
5. **Redundancy:** Item of support for contingency.
6. **N+1:** Abbreviation for REQUIREMENT plus a redundant item as support.
7. **Zero Footprint:** Term used to describe an item that does not use physical space on the floor.
8. **RMS:** Abbreviation for the term Rack Mount Slot, that refers to measurement unit in the physical space available to locate an IT equipment.
9. **HSSD:** Abbreviation for the term High Sensitive Smoke Detection, that refers to the smoke early detection system.
10. **UL-752:** Abbreviation for Underwriter Laboratories and the numeral of the standard which govern the ballistic resistance levels of different items.
11. **Razorback:** Device located in the perimeter of the container Kio/ATOM to connect the power supply cables of commercial power and power of moto-generator, as well as allows the connection of Internet links.
12. **LED:** Acronym for Light Emitting Diode, lighting bulb of low power consumption and long life.
13. **CCTV:** Abbreviation for Closed-Circuit Television.
14. **IT:** Information Technology.

## Claims

1. A mobile data centre (**100**) consisting in ISO standard containers (**1**) with dimensions from 3.048m to 16.154m (10 to 53 feet) in length, comprising a galvanized steel liner and adapted with a thermal insulation in their internal walls, configured to accommodate first and second sections, which are powered via an electric distribution panel (**21**),
a) the first section (**3**) locating heat exchangers (5) and main distribution panel (**21**); and
b) the second section (**4**) locating: at least two evaporators (**8**) controlled by means of a smart microprocessor (24) using the information received by two temperature and relative humidity sensors located inside of evaporators (**8**); an Automatic Transfer Switch (**6**) with insulation bypass having the ability to carry out maintenance operations without the requirement to shutdown equipment, an uninterruptible power supply system (**7**) with power capacity of 9kW, 20kW or 60kW with a redundant module in the configuration N+1; two, four, eight or fourteen cabinets (**9**) of 600mm in width, 1000 mm depth and 42 RMS to install the IT equipment, having each of cabinets (**9**) clamping means (**25**) to avoid movements formed by a uni-channel (**25a**) which is attached to container, a uni-channel (**25b**) attached to cabinet and a tensor (**25c**);
ladder type trays (**11**) installed perpendicularly on the top of each one of the cabinets, a bottom tray (**11b**) for data wiring and other upper (**11a**) for power wiring; as well as wire flexible organizers (**10**), the wire on the left (**10a**) for power and the wire on the right (**10b**) for data; and
a smoke early detection system that operates by means of an air particle analyser system, backed up in the event of fire using a control panel (**15**), two abort stations (**20**) that may prevent the expelling of the aerosol agent in the containers (**12**) in the event of a false possibility of fire, and four sirens (**18**), and two to four containers (**12**) which contain an aerosol agent;
**characterised in that** the items (9) that require to be permanently air-conditioned are located centrally in the second section along with the evaporators (8) so as to form a cool aisle (X) and a hot aisle (Y) on opposite sides thereof and **in that** at the bottom of the cabinets (9) there are bearings (22) and rails (23) to allow increasing the space in the front of the cabinets.

2. A mobile data centre according to Claim 1, wherein, in the second section (4), the components are arranged within the container so as to form a cool aisle (X) along one side thereof and a hot aisle (Y) along the opposite side thereof, and wherein the evaporators are, one located in the front in order to measure temperature and humidity in the supply air outlet to the cool aisle (X) and one located at the back in order to measure temperature and humidity in the return air outlet from the hot air aisle (Y).

3. The mobile data centre (**100**) according to claim 1, **characterized in that** it comprises additionally a surveillance video recording device comprising four high-resolution cameras, wherein two cameras of recording device surveillance are internal (**16a**) and two cameras are external (**16b**).

4. The mobile data centre (**100**) according to claim 1, **characterized in that** the removable floor panels (**13**) are made of aluminium and steel galvanized material.

5. The mobile data centre (100) according to claim 1, further **characterized in that** it comprises various accesses, wherein each of them comprises an access control (**2a**) by means of combination keys and an access ladder (**2e**) having the ability to be detachable.

6. The mobile data centre (**100**) according to claim 1, **characterized in that** it comprises a lighting system using LED technology (**17**).

7. The mobile data centre (**100**) according to claim 1, further **characterized by** an electrical connection centre and optical fibre inlet (**19**), wherein the electrical connection centre is divided in preferential 3 phase power (**191**), 1 neutral (**193**), 1 ground (**194**) and 3 phase emergency power (**192**), 1 neutral (**197**), 1 ground (**198**); an optical fibre inlet (**195**); an inlet (**196**) for communication wiring between emergency source and the switch (**6**); external services connections (**199**).

## Patentansprüche

1. Mobiles Rechenzentrum (100), bestehend aus ISO-Standardcontainern (1) mit Abmessungen von 3,048m bis 16,154m (10 bis 53 Fuß) in der Länge, umfassend eine verzinkte Stehlauskleidung und angepasst mit einer Wärmeisolierung in ihren Innenwänden, konfiguriert zur Aufnahme erster und zweiter Abschnitte, die über eine elektrisches Verteilerstafel (21) mit Strom versorgt werden,
a) wobei der erste Abschnitt (3) Wärmetauscher (5) und die Hauptverteilertafel (21) eingrenzt; und
b) der zweite Abschnitt (4) eingrenzt: mindestens zwei Verdampfer (8), die mittels eines intelligenten Mikroprozessors (24) gesteuert sind, der Informationen verwendet, die von zwei Temperatur- und relativen Feuchtigkeitssensoren empfangen werden, die innerhalb der Verdampfer (8) angeordnet sind; einen automatischen Übertragungsschalter (6) mit Isolationsbypass, der die Fähigkeit aufweist, Wartungsarbeiten durchzuführen, ohne die Notwendigkeit, Ausrüstung abzuschalten, ein unterbrechungsfreies Stromversorgungssystem (7) mit einer Leistung von 9 kW, 20 kW oder 60 kW mit einem redundanten Modul in der Konfiguration N +1; zwei, vier, acht oder vierzehn Schränke (9) mit einer Breite von 600 mm, einer Tiefe von 1000 mm und 42 Steckplätzen für die Rackmontage (RMS) zur Installation der IT-Ausrüstung, wobei jeder der Schränke (9) Klemmmittel (25) aufweist, um Bewegungen zu vermeiden, die durch einen Einkanal (25a), der an dem Container angebracht ist, einen Einkanal (25b), der an einem Schrank angebracht ist, und einen Spanner (25c) gebildet werden;
leiterartige Tabletts (11), die senkrecht auf der Oberseite eines jeden der Schränke installiert sind, ein unteres Tablett (11b) für die Datenverkabelung und andere obere (11a) für die Leistungsverkabelung; sowie drahtflexible Organisatoren (10), das Kabel links (10a) für die Stromversorgung und das Kabel rechts (10b) für die Daten; und
ein Rauchfrüherkennungssystem, das mittels eines Luftpartikelanalysesystems arbeitet, das im Brandfall gesichert ist, verwendend ein Bedienfeld (15), zwei Unterdrückungsstationen (20), die das Ausstoßen von Aerosolmittel in den Behältern (12) im Falle einer falschen Möglichkeit von Feuer verhindern können, und vier Sirenen (18), und zwei bis vier Behälter (12), die ein Aerosolmittel enthalten;
**dadurch gekennzeichnet, dass** die Gegenstände (9), die permanent gekühlt werden müssen, zentral in dem zweiten Abschnitt entlang der Verdampfer (8) angeordnet sind, um einen Kaltgang (X) und einen Warmgang (Y) an gegenüberliegenden Seiten derselben zu bilden und dass an der Unterseite der Schränke (9) Lager (22) und Schienen (23) sind, um zu ermöglichen, den Raum an der Vorderseite der Schränke zu vergrößern.

2. Mobiles Rechenzentrum (100) nach Anspruch 1, bei dem in dem zweiten Abschnitt (4) die Komponenten innerhalb des Containers derart angeordnet sind, um einen Kaltgang (X) entlang einer Seite desselben und einen Warmgang (Y) entlang der gegenüberliegenden Seite desselben zu bilden, und wobei die Verdampfer einer an der Vorderseite angeordnet ist, um die Temperatur und Feuchtigkeit in dem Zufuhrluftauslaß zu dem Kaltgang (X) zu messen und einer an der Rückseite angeordnet ist, um die Temperatur und Feuchtigkeit in dem Abluftauslaß aus dem Warmgangs (Y) zu messen.

3. Mobiles Rechenzentrum (100) nach Anspruch 1, **dadurch gekennzeichnet, dass** dieses zusätzlich ein Überwachungsvideoaufzeichnungsgerät mit vier hochauflösenden Kameras umfasst, wobei zwei Kameras der Aufzeichnungsgerätüberwachung intern (16a) und zwei Kameras extern (16b) sind.

4. Mobile Rechenzentrum (100) nach Anspruch 1, **dadurch gekennzeichnet, dass** die abnehmbaren Bodenplatten (13) aus Aluminium und verzinktem Stahlmaterial bestehen.

5. Mobiles Rechenzentrum (100) nach Anspruch 1, ferner **dadurch gekennzeichnet, dass** es verschiedene Zugänge umfasst, wobei jeder von ihnen eine Zugangskontrolle (2a) mittels Kombinationsschlüsseln und eine Zugangsleiter (2e) umfasst, die abnehmbar ist.

6. Mobiles Rechenzentrum (100) nach Anspruch 1, **dadurch gekennzeichnet, dass** es ein Beleuchtungssystem mit LED-Technologie (17) umfasst.

7. Mobiles Rechenzentrum (100) nach Anspruch 1, ferner **gekennzeichnet durch** ein elektrisches Verbindungszentrum und einen Lichtleitfasereinlass (19), wobei das elektrische Verbindungszentrum unterteilt ist in Vorzugs-3-Phasen-Leistung (191), 1 Neutralleiter (193), 1 Masse (194) und 3-Phasen-Notstromleistung (192), 1 Neutralleiter (197), 1 Masse (198); einen Lichtwellenleitereinlass (195); einen Einlass (196) zur Kommunikationsverdrahtung zwischen der Notfallquelle und dem Schalter (6); externe Dienstverbindungen (199).

## Revendications

1. Centre de données mobile (100) consistant en des conteneurs de norme ISO (1) avec des dimensions de 3, 048 m à 16, 154 m (10 à 53 pieds) en longueur, comprenant un revêtement en acier galvanisé et conçus avec une isolation thermique dans leurs parois internes, configurés pour recevoir des première et seconde sections, qui sont alimentées par l'intermédiaire d'un panneau de distribution électrique (21),
a) la première section (3) localisant des échangeurs thermiques (5) et un panneau de distribution principal (21) ; et
b) la seconde section (4) localisant : au moins deux évaporateurs (8) commandés au moyen d'un microprocesseur intelligent (24) à l'aide des informations reçues par deux capteurs de température et d'humidité relative situés à l'intérieur d'évaporateurs (8) ; un commutateur de transfert automatique (6) avec une dérivation d'isolation ayant la capacité de réaliser des opérations de maintenance sans l'exigence d'un équipement d'arrêt, un système d'alimentation électrique sans interruption (7) avec une capacité de puissance de 9 kW, 20 kW ou 60 kW avec un module redondant dans la configuration N+1 ; deux, quatre, huit ou quatorze armoires (9) de 600 mm en largeur, 1 000 mm en profondeur et 42 RMS pour installer l'équipement IT, chacune des armoires (9) ayant des moyens de blocage (25) pour empêcher des mouvements formés par un canal unique (25a) qui est fixé à un conteneur, un canal unique (25b) fixé à une armoire et un tenseur (25c);
des plateaux de type échelle (11) installés de manière perpendiculaire sur le dessus de chacune des armoires, un plateau inférieur (11b) pour un câblage de données et un autre supérieur (11a) pour un câblage de puissance ; ainsi que des organisateurs souples de fils (10), le fil sur la gauche (10a) pour la puissance et le fil sur la droite (10b) pour les données ; et
un système de détection précoce de fumée qui fonctionne au moyen d'un système d'analyseur de particules dans l'air, soutenu dans le cas d'un feu à l'aide d'un panneau de commande (15), deux stations d'interruption (20) qui peuvent empêcher l'émission de l'agent d'aérosol dans les conteneurs (12) dans le cas d'une possibilité fausse de feu, et quatre sirènes (18), et deux à quatre conteneurs (12) qui contiennent un agent d'aérosol ;
**caractérisé par le fait que** les éléments (9) qui nécessitent d'être conditionnés en air en permanence sont situés de manière centrale dans la seconde section avec les évaporateurs (8) de manière à former un couloir froid (X) et un couloir chaud (Y) à des côtés opposés de celle-ci et **par le fait que**, au niveau de la partie inférieure des armoires (9), il y a des roulements (22) et des rails (23) pour permettre une augmentation de l'espace à l'avant des armoires.

2. Centre de données mobile selon la revendication 1, dans lequel, dans la seconde section (4), les éléments sont agencés dans le conteneur de manière à former un couloir froid (X) le long d'un côté de celui-ci et un couloir chaud (Y) le long du côté opposé de celui-ci, et dans lequel les évaporateurs sont, un situé à l'avant de manière à mesurer la température et l' humidité dans la sortie d'air d'alimentation vers le couloir froid (X) et un situé à l'arrière de manière à mesurer la température et l' humidité dans la sortie d'air de retour à partir du couloir d'air chaud (Y).

3. Centre de données mobile (100) selon la revendication 1, **caractérisé par le fait qu'**il comprend en outre un dispositif d'enregistrement de vidéo surveillance comprenant quatre caméras haute résolution, dans lequel deux caméras de surveillance de dispositif d'enregistrement sont internes (16a) et deux caméras sont externes (16b).

4. Centre de données mobile (100) selon la revendication 1, **caractérisé par le fait que** les panneaux de plancher amovibles (13) sont réalisés en matériau galvanisé d'aluminium et d'acier.

5. Centre de données mobile (100) selon la revendication 1, **caractérisé en outre par le fait qu'**il comprend divers accès, dans lequel chacun d'eux comprend un contrôle d'accès (2a) au moyen de clés de combinaison et une échelle d'accès (2e) ayant la capacité de pouvoir être détachée.

6. Centre de données mobile (100) selon la revendication 1, **caractérisé par le fait qu'**il comprend un système d'éclairage utilisant une technologie de diode électroluminescente, DEL, (17).

7. Centre de données mobile (100) selon la revendication 1, **caractérisé en outre par** un centre de connexion électrique et une entrée de fibre optique (19), dans lequel le centre de connexion électrique est divisé en une alimentation à 3 phases préférentielle (191), 1 neutre (193), 1 terre (194) et une alimentation d'urgence à 3 phases (192), 1 neutre (197), 1 terre (198) ; une entrée de fibre optique (195) ; une entrée (196) pour un câblage de communication entre une source d'urgence et le commutateur (6) ; des connexions de services externes (199).
